# EUROPEAN PATENT APPLICATION

(11) **EP 2 341 523 A1**
(43) Date of publication of application: **06.07.2011**
(21) Application number: 09823104.6
(22) Date of filing: 08.04.2009
(51) Int. Cl.: H01J 3/38, G05F 1/67, H01L 31/042

(54) **SYSTEM AND METHOD FOR ENERGY OPTIMISATION IN PHOTOVOLTAIC GENERATORS**

(30) Priority: 30.10.2008 ES 200803165
(71) Applicant: ASEA BROWN BOVERI, S.A., 28037 Madrid (ES)
(72) Inventor: VEGA BETORET, Alejandro, E-28110 Algete (Madrid) (ES); ALMANSA LEANDREZ, Jose Alfonso, E-28037 Madrid (ES); SANZ LANDIVAR, Oscar, E-28917 Leganes (Madrid) (ES); DIEZ-HOCHLEITNER RUIZ, Alfredo, E-28043 Madrid (ES)
(74) Representative: Torner Lasalle, Elisabet
(86) International application number: PCT/ES2009/000190
(87) International publication number: WO 2010/049549

(57) **Abstract**

The system comprises:
- several main photovoltaic generators (Gp1-Gpn),
- several additional photovoltaic generators (Ga1-Gan), each one made up of several photovoltaic generator blocks (B1-Bn)
- several inverters (I1-In) intended to convert direct voltage/current into alternating voltage/current,
- several switching means (Sw1) arranged between the outputs of the main generators (Gp1-Gpn) and the inputs of the inverters (I1-In),
- several second switching means (Sw2) arranged between the outputs of the generator blocks (B1-Bn) and the outputs of the additional generators (Ga1-Gan),
and
- several means to automatically control both switching means (Sw1. Sw2) to selectively connect/disconnect the outputs of the main generators (Gp1-Gpn) and of the generator blocks (B1-Bn) to/from the inputs of the inverters (I1-In),

The method is provided to carry out said automatic control of the switching means.

## Description

### Field of the invention

The present invention relates to a system and method for energy optimization in photovoltaic generators, and in particular to a system and method based on the switching of different photovoltaic generators with respect to a series of inverters with the aim of optimizing inverter performance.

### State of the art

Photovoltaic installations are known which include a plurality of photovoltaic generators with their outputs connected to respective inverters to convert the generated energy into alternating current and, for example, to supply it synchronously to the electricity network.

Depending on the time of day, geographical location, date, weather, etc., many times the incidence of sun on the panels of said photovoltaic generators may be low or very low, so that the efficiency of performance of said inverters may also be low. In some cases, the continuous energy supplied by the generators (either current or voltage) may be below the minimum value acceptable by the inverter for it to start functioning.

For this reason, in the state of the art have been proposed different alternatives for the energy optimization of photovoltaic generators, and based on switching of the same respect of cited inverters, or based on the inclusion of additional generators, i.e. non-photovoltaic, in order to guarantee the energy supply.

By the application US2008078436A1 it is known a system including arrays of solar panels, each of which is connected to a respective inverter. In order to guarantee energy supply, when that coming from the solar panels is insufficient, the system includes an additional generator, in principle connected only to an additional inverter to collaborate in energy production. When the energy generated by the solar panels is very low or non-existent (at night for example), the additional generator connects to the inputs of the other inverters and increases their performance in a controlled way to substitute the panels in the generation of energy. The switching can be manual or automatic (for example, the system can be programmed to connect during the hours when the solar energy is very low). Said additional generator is "bio-friendly", such as one which comprises a motor using biodiesel fuel. This application does not propose selectively connecting the additional generator to only some of the inverters that are connected to the solar panels or leaving the additional generator disconnected from its respective inverter when the solar panels are supplying sufficient energy.

Patent JP2002073184 proposes a system for the generation of high efficiency photovoltaic energy even when solar radiation is low. For that purpose the system, which comprises a plurality of rows of solar panels, each of which is connected in principle to a respective inverter, has switching units which, in their most simple operation, disconnect one of the rows of panels from an inverter (when the output energy is below the minimum requirements of the inverter) and connect it to another of the inverters. In other embodiments, the system includes a control unit which monitors the outputs of the inverters and makes predictions regarding said outputs, with the aim of reconnecting the disconnected inverter to its row of panels when this would be efficient.

In patent ES2284577T3 an installation comprising photovoltaic generators is proposed that, for an embodiment, are formed from photovoltaic modules connected in series for the supply of alternating energy after corresponding conversion by inverters. The installation includes a plurality of switching devices activated by a control device to initiate a switching action that causes the separation of at least one generator from a first inverter and a connection of this generator to a second inverter when a condition occurs in which the input power to the second inverter drops to such a low level that it no longer works in its optimum efficiency zone. The installation includes several generators and several inverters, and the control device for the switching devices for disconnecting and connecting them according to the condition mentioned.

Both in patent JP2002073184 and ES2284577T3 is proposed disconnecting one or more photovoltaic generators from a first inverter to connecting them to a second inverter, either because the first inverter is working poorly or not at all efficiently (JP2002073184) or because the second inverter is working below its zone of optimum efficiency (ES2284577T3).

In none of said patents is it proposed to provide additional photovoltaic generators, not previously connected to another inverter, for their selective and discrete connection to an inverter that can handle more input power than that being supplied by the photovoltaic generator to which it is connected, with the aim of complementing the supply of energy of said generator when it may be necessary.

### Description of the invention

The present inventors consider necessary to offer an alternative to the state of the art, represented by the cited patents, which allows the energy optimization in photovoltaic generators, and specifically, the optimization of the efficiency of the inverters used, injecting them with a base or main power generated by a main photovoltaic generator and, when necessary, to inject additional power, also of photovoltaic origin, selectively variable in order to make a fine adjustment to complement (not substitute) the main power.

With said aim the present invention provides, in a first aspect, a system for energy optimization in photovoltaic generators that comprises, in a manner known per se, the following elements:
- a plurality of photovoltaic generators, each of which comprises an assembly of photovoltaic panels of a first type,
- a plurality of inverters intended to convert direct voltage/current into alternating voltage/current,
- first switching means arranged between the outputs of at least part of the photovoltaic generators and the inputs of said inverters, and
- control means intended to automatically control said switching means to selectively connect/disconnect the outputs of said photovoltaic generators to the inputs of said inverters.

In distinction from the conventional approaches, in the system proposed by the present invention, each of said photovoltaic generators is a main generator, and the system also comprises, in a characteristic manner:
- a plurality of additional photovoltaic generators, each of which is composed of photovoltaic generator blocks comprising respective assemblies of photovoltaic panels of a second type, and
- second switching means arranged between the outputs of the photovoltaic generator blocks and the outputs of said additional photovoltaic generators in order to apply one or more of the photovoltaic generator blocks to said outputs of the additional photovoltaic generators.

The control means of the system proposed by the invention are provided to control, automatically, also the second switching means, for selectively connecting/disconnecting one or more of said photovoltaic generator blocks with respect to the output of the additional photovoltaic generator to which they belong and in relation to the inputs of the inverters, with the aim of supplying additional power to them, which is a function of the number of connected blocks and less than that supplied by the main photovoltaic generators.

In the system proposed by the first aspect of the invention, the mentioned control means may comprise one or more processing systems intended to carrying out the control of the switching means depending on the values of operational parameters of the energy optimization system and/or of the assemblies of photovoltaic panels, with such values being detected and/or measured and/or calculated depending on the particular system.

Regarding the detected operational parameters, in order to carry out said detections, the system comprises a series of sensors that are disposed in different elements of the system and that are intended to detect the values of different operational parameters, with the outputs of these sensors being connected to the inputs of the processing system(s) to supply the values of the detected operational parameters through suitable electric/electronic circuitry.

The proposed processing system has access to historical data regarding operational parameters of the system, and may also be configured to carry out the control of the switching means also according to said historical data.

The present invention concerns, in a second aspect, to a method for energy optimization of photovoltaic generators that comprises connecting/disconnecting, selectively and automatically, the outputs of a plurality of photovoltaic generators, each of which being formed by a respective assembly of photovoltaic panels, to the inputs of a plurality of inverters being intended to convert direct voltage/current into alternating voltage/current.

The proposed method by the second aspect of the invention comprises carrying out said selective connection for at least one specific inverter (although in general for a plurality of inverters in a similar way), by means of carrying out sequentially the following steps:
- connecting the output of at least one main photovoltaic generator, formed by an assembly of photovoltaic panels of a first type, to the input of a specific inverter, to supply it with a base or main power, and
- further connecting to the input of said specific inverter, at least one additional photovoltaic generator, to supply an additional power, without reaching the maximum input power of each inverter, representing a fine adjustment, complementary to said main power.

In general, and with the aim that the mentioned additional power is variable depending on the needs of the inverter to which it supplies said additional power as part of said fine adjustment, each one of said additional photovoltaic generators may comprise photovoltaic generator blocks comprising respective assemblies of photovoltaic panels of a second type, and said step of fine adjustment may comprise selectively and automatically connecting/disconnecting one or more of said photovoltaic generator blocks, by their outputs, to the output of the additional photovoltaic generator to which they belong to supply said output power with a value depending on the number of connected generator blocks.

For another embodiment, the variation of the output power of each additional photovoltaic generator is carried out in another different way to the described above, without including said blocks, such as, for example, using a regulatory device to regulate, manually or automatically, said output power.

Regarding the mentioned selective disconnection, the method comprises carrying it out, for said or another specific inverter, by carrying out the following step:
- disconnecting from the output of said additional photovoltaic generator one or more of said additional photovoltaic generator blocks, with the aim of slightly reducing the additional power supplied,
   and if necessary the following step:
- disconnecting from the input of a specific inverter at least the output of the main photovoltaic generator, with the aim of not supplying it any main power, after having previously also removed the additional power.

In a subsequent section will be described embodiments relating to the connection and the disconnection of different generators and blocks in different working situations.

For an embodiment, and with the aim of injecting more or less power to each inverter in order to keep it functioning within its tolerances and at the point of maximum efficiency, some versions of the method comprise carrying out this selective connection/disconnection depending on some or all of the following values:
- values of operational parameters of the system that include said photovoltaic generators and/or of the assemblies of photovoltaic panels and/or of any of the elements used by the energy optimization method, said values being detected and/or measured and/or calculated,
- and/or of real historical data regarding operational parameters of the system,
- and/or of theoretical data referring to forecasts of functioning and/or environmental conditions.

With regard to the aforementioned operating parameters, are defined as follows to implement the proposed method: temperature, of the photovoltaic generator plant and/or of each panel assembly, instantaneous irradiation, wind speed, dirt on the panels, losses in cables, voltages, currents and power levels of each inverter, of the plant, of each photovoltaic generator, or a combination thereof.

Whenever possible, it may be desirable to use all of these cited operational parameters, whether they be detected via sensors (for example wind speed, instantaneous irradiation, etc.), measured (for example voltages and currents), or calculated (for example powers, estimated losses, etc.).

Regarding to the referred historical data, these are at least one from the group that includes the following data or data clustering: annual irradiation curves to a resolution of a minute, annual hourly average temperatures and maximal efficiency curves of each inverter, or a combination thereof.

According to an embodiment, and with the aim of carrying out said selective connection/disconnection automatically, the method comprises pre-establishing a series of theoretical set points relating theoretical power to be supplied, obtained from a specific number of main and additional photovoltaic generators, and of additional generator blocks, to connect to each inverter according to at least theoretical data of radiation predicted for the area where the photovoltaic generator plant is installed and of real historical data previously measured.

For a more elaborated variant of said embodiment, the method comprises pre-establishing said theoretical set points according to the detected and/or measured and/or calculated operational parameters previously described.

The method comprises classify said theoretical set points into a series of situations or cases that, for an embodiment, are the following cases, which have been established from said theoretical data, historical data and/or operational parameters:
a) dawn;
b) twilight;
c) cloud cover;
d) wind or snow;
e) morning mist;
f) low radiation;
g) maintenance tasks.

The method comprises detecting the real approximation to one of said set points or situational cases and connecting the generators associated with said set point to each inverter, with the aim of injecting it with power whose theoretical value represents said set point.

That is, if, for example, the method detects or determines by theoretical, historical and/or any of the operational parameter data that, in the geographical zone where the photovoltaic generators are located, twilight is approaching, i.e., the so-called case b), the method will connect the generators associated with the set point of the b) situational case for each inverter, that in general for such situation, where the energy generated is relatively low, this may involve connecting the highest possible number of photovoltaic generators, including additional photovoltaic generators, to each inverter, or if the energy supplied to each inverter is still too low, some of the inverters may be disconnected and their photovoltaic generators may be connected to the remaining inverters, thus increasing the power supplied to the remaining inverters.

In any case such set points, which may establish which selection of connections/disconnections to carry out for each situational case, are theoretical, so that the estimation of power to inject following the pre-established selections can be erroneous or not fully appropriate for the real situation. Thereby the method of the present example comprises compensating for the differences between the real power supplied to each inverter and the theoretical power related to the applied set point, by the connection/disconnection of one or more photovoltaic generator blocks, that is performing fine adjustment of the supplied power, and to the extent that the differences are very large, it may also be possible to connect/disconnect the main generators.

### Brief description of the drawings

The foregoing and other advantages and features will be better understood from the following detailed description of exemplary embodiments with reference to the accompanying drawings, to be taken by way of illustration and non limitative, in which:
FIG. 1 is a schematic representation of a plant or conventional photovoltaic installation, connected to the electricity network;
FIG. 2 shows schematically in detail several elements of the proposed system, including the different generator blocks included within each additional photovoltaic generator for an embodiment; and
FIG. 3 shows schematically the control means included in the system proposed by the first aspect of the invention, for an embodiment in which said control means include a main processing system, in this case a master PLC, and a series of secondary processing systems, in this case field PLCs.

### Detailed description of exemplary embodiments

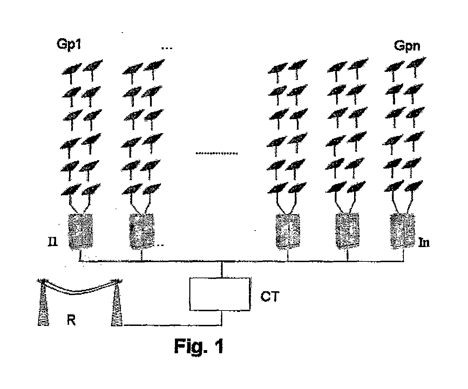

Firstly, referring to FIG. 1, in this the basic elements included in a conventional photovoltaic plant or installation can be seen, namely:
- Photovoltaic field: It is formed by a series of photovoltaic generators Gp1-Gpn, each of which in turn formed by the interconnection in series and parallel of a specific number of photovoltaic modules for capturing sunlight and transforming it into electrical energy, generating a direct current proportional to the received solar irradiation, and which are installed on solar trackers or structures.
- Inverters: Electronic devices, based on power electronics, that convert direct energy (current/voltage) into alternating energy (current/voltage) with characteristics that are suitable for adding to the electricity network, in order to allow the photovoltaic installation to operate in parallel with the electricity network R. In FIG. 1 have been indicated inverters n with the references I1...In.
- Protections: This part comprises a configuration of elements (collectively referenced as CT in FIG. 1) that act as a connection interface between the photovoltaic installation and the network R for safety reasons, both for people and for the components comprising the photovoltaic installation.

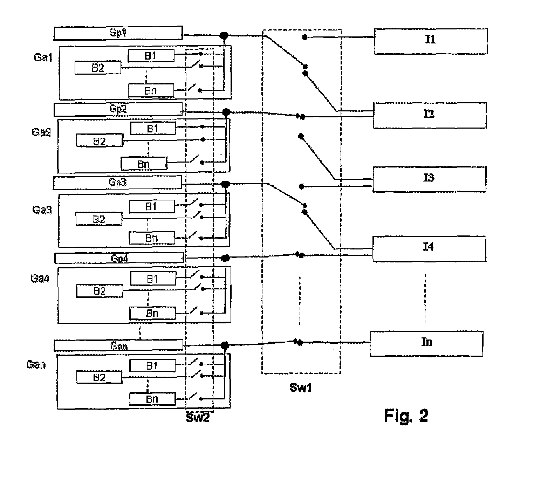

The optimization system proposed by the present invention, according to an exemplary embodiment, is illustrated in detail in FIG. 2. In this figure it can be seen that the main photovoltaic generators Gp1-Gpn can be connected, through first switching means Sw1, to different inverters I1-In, in a way that is already known. In the case illustrated, each main generator Gp1-Gpn can be connected to one of two inverters I1-In, the first Gp1 to the inverter I1 or to I2, the second Gp2 to the I2 or I3, and so on.

In said FIG. 2, several additional photovoltaic generators Ga1-Gan are also illustrated, each of which includes a plurality of photovoltaic generator blocks B1-Bn, with n, in general, corresponding to the number of total inverters.

In FIG. 2, the second switching means Sw2 cited above can be seen arranged between the outputs of the photovoltaic generator blocks B1-Bn and the outputs of the additional photovoltaic generators Ga1-Gan.

Specifically, in the example illustrated in this FIG. 2, in the first additional generator Ga1, only the output of the first generator block B1 is connected to the output of the additional generator Ga1, in the second additional generator Ga2, the outputs of the first two blocks B1 and B2 are connected to the output of the generator Ga2, and in the remaining additional generators is not connected any block.

In general, the number of generator blocks B1-Bn may be determined according to the characteristics of each photovoltaic plant, and in particular by the following characteristics:
- Real performance ratio of the plant.
- Average temperature.
- Estimated irradiation.
- Installation type (fixed, 1 axis, or 2 axes).
- Type and power of the inverters.

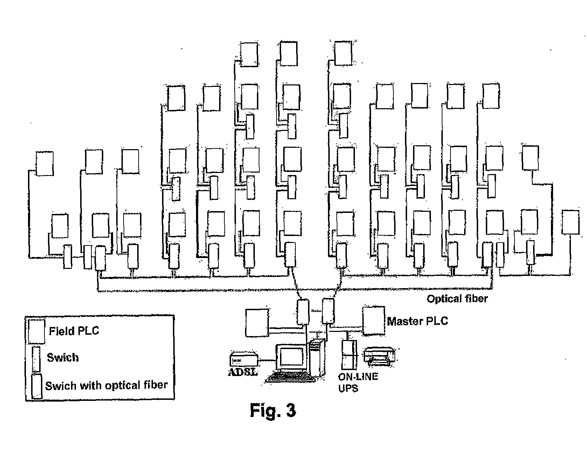

The control means controlling these switching means Sw1 and Sw2 are not illustrated in FIG. 2, but are illustrated separately in FIG. 3 for an exemplary embodiment.

Continuing with FIG. 2, it can be seen how the output of each of the additional photovoltaic generators Ga1-Gan is connected to the output of one respective main photovoltaic generator Gp1-Gpn, so that on activating the first switching means Sw1 to connect, for example, the first main generator Gp1, the connection of the first additional generator Ga1 will also be made to the same inverter to which the main generator Gp1 is connected, in this case (FIG. 2) with the inverter I2.

For another exemplary embodiment, not illustrated, it is considered to connect the output of the additional generators Ga1-Gan to the inverters I1-In through other switching means, for example third switching means acting independently of the first switching means Sw1.

Although both the first switching means Sw1 and the second switching means Sw2 have been represented grouped by rectangles with dotted lines encompassing all the switches included in them, each of said switches is controlled individually by the control means.

For an exemplary embodiment, each of the photovoltaic generator blocks B1-Bn is adapted to supply approximately between 0.1% and 10% of the maximum power acceptable to each inverter I1-In (taking into account the tolerances) once the corresponding system losses (temperature, cabling, reflection, shadows, orientation, inclination, dirt, etc.) have been applied.

Regarding to the main generators Gp1-Gpn, each of which is intended to supply a maximum output power under conditions of maximum radiation of less than or equal to approximately 95%-100% of the maximum power acceptable to each inverter I1-In (taking into account the tolerances), once the corresponding losses to the system (temperature, cabling, reflection, shadows, orientation, inclination, dirt, etc.) have been applied.

Usually (without an optimization system), main generators may be designed with a power that is higher than the nominal power of the inverter (e.g., 116 kW for an inverter of 100 kW). These extra 16 kW may be estimated to compensate for losses that may occur in the generator due to dirt in the modules, cabling, bad orientation of the modules, shadows and reflection. So, the specified power of each solar module (e.g., a module of 175 W) is the power under optimal conditions of incident irradiation and, consequently, the power calculated for an inverter may depend on the incident irradiation (the irradiation can decrease due to cloud cover, etc.), that is, if, for example, the inverters I1-In accept a maximum input power of 100 kW and each of them is connected to a main generator Gp1-Gpn of 116 kW (100 kW + 16 kW estimated for losses), only in the summer months and for a 'few hours' (June, July, August) the main generator Gp1-Gpn will supply the 100 kW to the inverter I1-In. By contrast, in winter, the power supplied by the main generator Gp1-Gpn to the inverter I1-In may be, for example, about 80 kW for a 'few hours'. Over the remainder of the hours, the power supplied by the generator to the inverter may be less.

By means of the optimization system proposed by the present invention, and in particular by means of the additional generators Ga1-Gan, responsible to supply additional power for fine adjustment, acting on second switching means Sw2, the power supplied to the operative inverter I1-In may be maintained for the maximum number of hours, either in winter or in summer.

In general, the assembly of blocks B1-Bn of each additional generator Ga1-Gan is designed to supply a power of up to approximately 40% (ignoring losses) of the maximum power acceptable by each inverter I1-In. For example, for the case of using inverters of 100 kW of maximum input power and of solar modules of 175 W, additional generators Ga1-Gan may be used that are each capable of supplying approximately 37.8 kW, consisting of twelve series, or blocks B1-B12, of eighteen solar modules, each series providing approximately 3.15 kW.

As the incident irradiation decreases, more series or blocks B1-Bn of the additional generators Ga1-Gan are connected with the aim of maintaining, according to FIG. 2, a constant power of approximately 100 kW at the common output of a main generator and of one additional generator during the maximum number of hours.

For a preferred exemplary embodiment, the different blocks B1-Bn correspond to different series of solar modules or panels of respective solar trackers or supporting structures, and the main generators Gp1-Gpn correspond to groups of solar trackers or supporting structures connected in series and/or parallel. That is, what have previously been called assemblies of photovoltaic panels of the first type refers in this case to these groups, and what was called assemblies of photovoltaic panels of the second type refers to these series of solar modules.

That is, the system, therefore, works with the following two types of switches:
a) Switches of lines (groups of solar trackers) Gp1-Gpn, when the power to supply to each inverter is very high, and
b) Switches of series of solar panels B1-Bn, when a fine adjustment is being made to the optimum power to supply to each inverter.

By means of the switching of the series or blocks B1-Bn (fine adjustment) is achieved that, even at times when there is a decrease in power due to the passage of a simple cloud, the system reacts in real time and supplies more solar power to the inverters I1-In.

In FIG. 3 exemplary control means of the proposed optimization system have been illustrated for an exemplary embodiment in which a series of field PLCs, or slave automata, are included, each of them moving a respective solar tracker (not illustrated) with a specific number of panels grouped in one or several parallel series.

The electrical production outputs of all these series may be collected in circuit boards, which are not illustrated, where the currents are detected and the control of additional power, or fine adjustment, is carried out, that is, the switching of blocks B1-Bn by acting on the second switching means Sw2. For this, the measurements of the various series of panels are sent to the nearest field PLC, which then proceeds with the control of the additional power, or fine adjustment.

In general, and apart from fine power control, these circuit boards have the function of grouping all the electric current that arrives into a single conductor of larger cross-section, which is known as a line, which is distributed to a switching box, where the switching between the main generators Gp1-Gpn and the inverters I1-In (not illustrated in FIG. 3) occurs, acting on the first switching means Sw1 by the control of one or more PLCs, or master or main automata (two have been illustrated in FIG. 3), which collect the data referring to the solar trackers or supporting structures through a communications network consisting of different communication lines (some may comprise optical fiber), and of different network switches that interconnect the master PLC with all the field or slave PLCs.

In said FIG. 3, a PC has also been illustrated, with a series of peripherals (printer, ADSL modem, on-line UPS, etc.), which schematically representing a control SCADA, in which the data for supervision are collected and which in turn controls the master PLCs in order to carry out the mentioned control of the switching means, according to any of the exemplary embodiments of the method proposed by the second aspect of the invention mentioned above.

Following the description of FIG. 3, for an exemplary embodiment, the slave and master automata may perform the following functions in real time.
A) Slave automata:
   - Actuation, in the case of plants with solar trackers of one or two axes, of each PLC on the movement motors of each tracker so that, with a precision of less than 1°, an optimal position of both azimuth and zenith directions is achieved to obtain the maximum power in the photovoltaic panels.
   - Measurement of the currents and voltages of each of the panel series, both of the assembly of panel series making up the base power generators (Gp1-Gpn) and the assembly of panel series making up the fine adjustment power generators (Ga1-Gan).
   - Communication of all data measured to the master PLC.
   - Actuation on the switching matrix of the blocks B1-Bn of the additional generators Ga1-Gan under the request of the master PLC, through the second switching means Sw2.
B) Master PLC
   - It is measuring and calculating the actual instantaneous irradiation.
   - It is measuring and calculating the actual temperature of the plant.
   - It is measuring the wind speed.
   - It is measuring the voltage, current, and power parameters of each inverter.
   - It acts on the switching matrix to supply both the base power and the fine adjustment power (under the demand of the slave PLCs) to the inverter(s), determined by a model of maximum efficiency representative of the proposed method.

Likewise, the control means keep in memory data of:
- Historical data of annual irradiation to a resolution of one minute.
- Historical data of annual hourly average temperatures.
- Maximum efficiency curve of the inverter.

In the system proposed by the present invention, for an exemplary embodiment, the described switching means Sw1 and Sw2 constitute switching matrices supported by contactors, switchers, relays, breakers and fuses, capable of connecting the lines both of base power, that is that coming from the main generators Gp1-Gpn, and of fine adjustment or additional power, that is that coming from blocks B1-Bn of the additional generators Ga1-Gan, to one or several inverters I1-In.

This system of switched power supply can be made as complicated as desired, in general applying the method proposed by the second aspect of the invention, such as to permit each main generator Gp1-Gpn to selectively connect to at least two inverters and selectively connect/disconnect at least one block B1-Bn of additional power. Such is the case illustrated by the FIG. 2 and previously described.

Following an exemplary embodiment of use of the system proposed according to the method of the second aspect of the invention, a photovoltaic plant in controlled with the following operating scheme:
a.) Before dawn, the control means have connected part of the main generators Gp1-Gpn, and their associated additional generators Ga1-Gan, to only a part of the inverters I1-In, keeping the remainder of the inverters I1-In disconnected. Supposing a plant of 1 MW formed by ten inverters of 100 kW, the system would supply all the anticipated production into only five inverters, disconnecting the other five inverters (case of switching to two inverters, as illustrated in FIG. 2).
b.) As the day dawns, the various photovoltaic generators or FV, Gp1-Gpn and Ga1-Gan, start to supply the generated power to the five selected inverters and input currents and voltages of the functioning inverters begin to be detected. This situation continues until the total power supplied to each inverter reaches the nominal optimum power level for disconnection (different from the nominal optimum power level of the inverter, which may be specified at around 50% of load), obtained through the application of mathematical algorithms over the performance curve of the inverter and taking into account the number of inverters that are involved in the switching. Once this value has been reached, the control means act on the switch matrix, specifically on the first switching means Sw1. and connect each inverter I1-In to a main generator Gp1-Gpn with the additional one associated generator Ga1-Gan, that is, its base power and its fine adjustment power. This process may maintain the inverters I1-In in the optimum performance range, minimizing losses of power due to the performance of the inverter.
c.) As the day progresses, the production of energy of the FV, Gp1-Gpn and Ga1-Gan generators increases and the system continues detecting the input currents and voltages at the inverters I1-In. When these currents reach approximately 100% of the maximum acceptable value by the inverter or the total power supplied reaches the input limit power accepted by the inverter, the control means start to sequentially disconnect as many additional generator blocks B1-Bn (of fine adjustment power blocks) as necessary to bring the input currents to the range acceptable by the inverter, by means of the control of the second switching means Sw2.
d.) The previous situation is maintained throughout the hours of maximum solar radiation in such a way that, depending on the actual solar radiation, the temperature and instantaneous cloud cover, the control means connect and disconnect in real time the assembly of fine power adjustment blocks B1-Bn necessary to always maintain approximately the maximum power acceptable by the inverter, by controlling the second switching means Sw2.
e.) When twilight approaches, the cycle inverts and when the power that is being supplied to each inverter I1-In reduces below the nominal optimum switching point, calculated in the same way as the nominal power optimum point for disconnection, the control means change the switching matrix so that the power generated is supplied to one half of the inverters (in the case of switching to 2), disconnecting the inverters that are not working, acting on the first switching means Sw1.

Although in all the previous description mention is made of the input power for each inverter I1-In as a determining factor and referent for carrying out the various selective switching operations, so that each inverter continues operating with high performance and without being damaged, both the system and the method proposed by the present invention also take as reference the input current of each inverter I1-In for the same end, that is, to control the various switching operations, preventing the maximum acceptable input to each inverter from being exceeded.

By the system and method proposed by the present invention, the incident solar irradiation during the whole year can be utilized with higher efficiency, acquiring the present invention major importance, in particular, during the winter and autumn months (fewer hours of sunlight, ice, snow, etc.), and during the possible maintenance tasks carried out on the photovoltaic field FV, for which some of the generators disconnected from one inverter for its maintenance can be connected to another inverter, thereby remaining operative.

One skilled in the art could introduce changes and modifications in the embodiments described without departing from the scope of the invention as defined in the appended claims.

## Claims

1. System for energy optimization in photovoltaic generators, of the type that comprises:
- a plurality of main photovoltaic generators (Gp1-Gpn), each of which comprises a respective assembly of photovoltaic panels of a first type,
- a plurality of inverters (I1-In) configured to convert direct voltage/current into alternating voltage/current,
- first switching means (Sw1) arranged between the outputs of at least part of said photovoltaic generators and the inputs of said inverters (I1-In), and
- control means configured for controlling, automatically, said switching means (Sw1) in order to connect/disconnect selectively the outputs of said photovoltaic generators to the inputs of said inverters (I1-In),
said system being **characterized in that** it comprises:
- a plurality of additional photovoltaic generators (Ga1-Gan), each of which includes some photovoltaic generator blocks (B1-Bn) comprising respective assemblies of photovoltaic panels of a second type, and
- second switching means (Sw2) arranged between the outputs of said photovoltaic generator blocks (B1-Bn) and the outputs of said additional photovoltaic generators (Ga1-Gan),
said control means being configured to also control, automatically, said second switching means (Sw2) in order to selectively connect/disconnect one or more of said photovoltaic generator blocks (B1-Bn), with respect to the output of the additional photovoltaic generator (Ga1-Gan) to which they belong and with respect to the inputs of said inverters (I1-In), in order to supply an additional power to the inverters in accordance with the number of connected blocks (B1-Bn) and lesser with respect to the power supplied from the main photovoltaic generators (Gp1-Gpn).

2. System according to claim 1, **characterized in that** the output of each of said additional photovoltaic generators (Ga1-Gan) is connected to the output of a corresponding one of said photovoltaic generators (Gp1-Gpn) that act as main generators.

3. System according to claim 1 or 2, **characterized in that** each of said photovoltaic generator blocks (B1-Bn) is arranged to supply approximately between 0.1 % and 10% of the maximum power acceptable by each inverter (I1-In).

4. System according to any of the preceding claims, **characterized in that** each of said main photovoltaic generators (Gp1-Gpn) is configured to supply, in conditions of maximum radiation, a maximum output power that is equal to or less than the maximum power acceptable by each inverter (I1-In).

5. System according to claim 1, **characterized in that** said control means comprises at least one processing system configured to carry out said control of said switching means (Sw1, Sw2) depending on values of detected and/or measured operational parameters of the energy optimization system and/or of the assemblies of photovoltaic panels.

6. System according to claim 5, **characterized in that** it also comprises to carry out said control of said switching means (Sw1, Sw2) depending on values of calculated operational parameters of the energy optimization system and/or of the assemblies of photovoltaic panels.

7. System according to claim 5, **characterized in that** it comprises a series of sensors arranged in different elements of the system and configured to detect values of different operational parameters, being the outputs of said sensors connected to inputs of said processing system to supply it said values of said detected operational parameters.

8. System according to claim 5, 6 or 7, **characterized in that** said operational parameters are at least one selected from the group consisting of the following parameters: temperature of a plant including said photovoltaic generators (Gp1-Gpn, Ga1-Gan) and/or of each panel assembly, instantaneous irradiation, wind speed, voltages, currents, and powers of each of the inverters (I1-In), of each photovoltaic generator (Gp1-Gpn, Ga1-Gan) and of each photovoltaic generator block (B1-Bn), or a combination thereof.

9. System according to any of the claims 5 to 7, **characterized in that** said at least one processing system has access to some historical data relative to operational parameters of the system, and **in that** is configured to carry out said control of said switching means (Sw1, Sw2) also depending on said historical data.

10. System according to any of the claims 5 to 7, **characterized in that** said at least one processing system has access to some historical data relative to operational parameters of the system, and **in that** is configured to carry out said control of said switching means (Sw1, Sw2) also depending on said historical data which comprise at least one from the group consisting of annual irradiation curves at a resolution of one minute, annual hourly average temperatures and curves of maximum efficiency of each inverter, or a combination thereof.

11. Method for energy optimization in photovoltaic generators, of the type which comprises connecting/disconnecting, selectively and automatically, the outputs of a plurality of photovoltaic generators, each of which comprises a respective assembly of photovoltaic panels, with the inputs of a plurality of inverters configured to convert direct voltage/current into alternating voltage/current, said method being **characterized in that** it comprises carrying out said selective connection, for at least one specific inverter, by sequentially performing the following steps:
- connecting the output of at least one main photovoltaic generator, formed by an assembly of photovoltaic panels of a first type, to the input of a specific inverter, to supply it with a base or main power, and
- further connecting to the input of said specific inverter, at least one additional photovoltaic generator, to supply an additional power, without reaching the maximum input power of each inverter, representing a fine adjustment, complementary to said main power.

12. Method according to claim 11, **characterized in that** each of said additional photovoltaic generators consists of photovoltaic generator blocks consisting of respective assemblies of photovoltaic panels of a second type, and **in that** said step of fine adjustment comprises connecting/disconnecting, selectively and automatically, one or more of said photovoltaic generator blocks by its outputs, with respect to the output of the additional photovoltaic generator to which they belong, to supply said output power with a value dependent on the number of generator blocks connected.

13. Method according to claim 12, **characterized in that** it comprises carry out said selective disconnection for said particular inverter by carrying out the following step:
- disconnecting one or more of said additional photovoltaic generator blocks from the output of said additional photovoltaic generator;
and, if necessary, the following step:
- disconnecting at least the output of said main photovoltaic generator from the input of said specific inverter.

14. Method according to any of the claims 11 to 13, **characterized in that** in order to inject more or less power supply to each investor to keep it running within tolerances and at the point of curve with maximum efficiency, the method comprises carrying out said selective connection/disconnection depending on values of operational parameters of the system that includes said photovoltaic generators, and/or of said assemblies of photovoltaic panels and/or of any of the elements used by the method for energy optimization, said values being detected and/or measured and/or calculated, and/or depending on real historical data about operational parameters and/or on theoretical data about forecasts of functioning and/or of environmental conditions.

15. Method according to claim 14, **characterized in that** it comprises pre-establishing a series of theoretical set points relating a theoretical power to be injected, to be obtained by a specific number of main photovoltaic generators, of additional photovoltaic generators and of additional generator blocks, to be connected to each inverter depending on theoretical radiation forecast data for the area where the photovoltaic generators plant is installed and on real historical data measured previously.

16. Method according to claim 15, **characterized in that** it also comprises pre-establishing said theoretical set points depending on said detected and/or measured and/or calculated operational parameters.

17. Method according to claim 15 or 16, **characterized in that** it comprises classifying said set points into the following cases established from said theoretical data, historical data, and/or said operational parameters:
a) dawn;
b) twilight;
c) cloud cover;
d) wind or snow;
e) morning mist;
f) low radiation;
g) maintenance tasks.

18. Method according to claim 15 or 16, **characterized in that** it comprises detecting the real approximation to one of said set points or cases, and connecting the generators associated with said set point to each inverter, in order to inject it with the power whose theoretical value represents said set point.

19. Method according to claim 15 or 16, **characterized in that** it comprises compensating the differences between the real power injected to each inverter and the theoretical power relative to the applied set point, by connecting or disconnecting one or more of said photovoltaic generator blocks.
